# EUROPEAN PATENT SPECIFICATION

(11) **EP 2 113 951 B1**
(45) Date of publication and mention of the grant of the patent: **10.06.2015**
(21) Application number: 08740063.6
(22) Date of filing: 08.04.2008
(51) Int. Cl.: G03B 17/54, G03B 21/20, G03B 33/12, H01L 33/46, H01L 33/50, H01L 33/58, G03B 21/14

(54) **ILLUMINATING DEVICE, PROJECTOR AND CAMERA**
BELEUCHTUNGSVORRICHTUNG, PROJEKTOR UND KAMERA
DISPOSITIF D'ECLAIRAGE, PROJECTEUR ET CAMERA

(30) Priority: 17.04.2007 JP 2007108272
(43) Date of publication of application: 04.11.2009
(73) Proprietor: Nikon Corporation, Tokyo 100-8331 (JP)
(72) Inventor: FUJINAWA, Nobuhiro, Tokyo 100-8331 (JP)
(74) Representative: Gulde & Partner
(86) International application number: PCT/JP2008/056960
(87) International publication number: WO 2008/129945

(56) References cited:
- WO-A1-2004/068599
- JP-A- 58 131 781
- JP-A- 2000 022 220
- JP-A- 2004 228 143
- JP-A- 2006 064 859
- JP-A- 2007 073 733
- US-A1- 2003 201 451
- US-A1- 2006 221 310
- US-A1- 2006 227 302

## Description

### TECHNICAL FIELD

The present invention relates to an illuminating device, a projector and camera equipped with a solid-state light emitting element such as a light emitting diode (hereafter referred to as an "LED") light source,.

### BACKGROUND ART

There are illuminating devices and projectors known in the related art, equipped with light sources constituted with LEDs (see, for instance, patent reference 1).
Patent reference 1: Japanese Laid Open Patent Publication No. 2005-183470.
Patent reference 2: US Patent Application 2006/0221310.

Furthermore, the following patent applications disclose an illuminating device comprising a LED light source and a reflector. Patent reference 3: International Patent Application WO 2004/068599. Patent reference 4: US Patent Application 2003/0201451. Patent reference 5: Japanese Patent Publication No. 2000-022220. Patent reference 6: US Patent Application No. 2006/0227302.

### DISCLOSURE OF THE INVENTION

### PROBLEMS TO BE SOLVED BY THE INVENTION

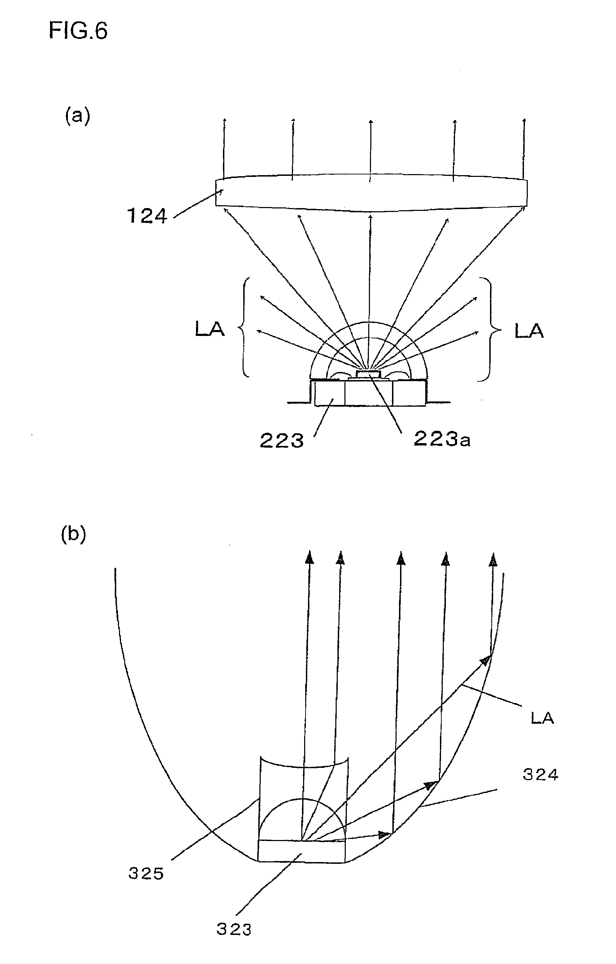

Some of the light emitted from the LED light source in an illuminating device or a projector in the related art may fail to reach the lens disposed to the front of the LED light source, as shown in FIG. 6 (a) and, in such a case, the emitted light is not utilized efficiently.

### MEANS FOR SOLVING THE PROBLEMS

An illuminating device according to the present invention comprises: an optical system, a solid-state light emitting element that includes a light source disposed on a base member, the light source being coated with phosphor and adapted to emit first light toward the optical system, the first light comprising a second light emitted from the light source and phosphorescent light emitted from the phosphor excited with the second light from the light source; a cover member having a hollow hemispherical form and disposed above the_base member, wherein a reflective film is formed on a reflective portion corresponding to an outer surface of the cover member except a transmissive portion located at the apex of the cover member, wherein the reflective portion is configured to reflect a part of the first light emitted from the solid-state light emitting element, which is not directed toward the optical system, back to the solid-state light emitting element directly so that the reflected light is used to excite the phosphor, and wherein the transmissive portion is located at the apex of the cover member in correspondence to the optical system for transmitting another part of the first light directed toward the optical system.

The solid-state light emitting element preferably is adapted to emit the first light as white light. Furthermore, it is preferred that the second light emitted from the light source is blue light constituted of a blue color component and the phosphor is adapted to emit yellow light constituted of a yellow color component as the phosphor is excited with exciting light constituted with the blue light.

In the illuminating device described above, the reflective portion may be a dichroic mirror that reflects a component of exciting light

In the illuminating device described above, the optical system may be adapted to condense the first light emitted from the solid-state light emitting element and to emit the condensed light. Furthermore, the optical system is preferably an optical collimator system adapted to convert the light emitted from the solid-state light emitting element to substantially parallel light and then to emit the substantially parallel light. It is preferable that the reflective portion of this illuminating device assumes a structure that allows the reflective portion to reflect part of the light emitted from the solid-state light emitting element, which is other than effectively utilized light determined in correspondence to a numerical aperture of the optical system and a distance between the optical system and the solid-state light emitting element, toward the solid-state light emitting element.

The cover member is preferably disposed so that a center of the hollow hemispherical form is aligned with a center of the solid-state light emitting element, and the reflective portion may be disposed at a surface of the cover member. The cover member includes a first area where the reflective portion is disposed and a second area through which the light from the light source is transmitted; and it is possible that a radius of curvature of the second area is smaller than a radius of curvature of the first area and the second area has a positive refractive power.

The illuminating device described above further comprises: a cover member assuming a hollow hemispherical form and disposed so that a center of the hemispherical hollow form is aligned with a center of the solid-state light emitting element; and a dome member disposed in close contact with an outer surface of the cover member, and the reflective portion may be disposed at a surface of the dome member.

A projector according to the present invention comprises: a projection image forming unit that forms a projection image to be projected; an illuminating device according to any one of claims 1 through 10, which illuminates the projection image forming unit; and an optical system that radiates illuminating light from the illuminating device onto the projection image forming unit and projects an image formed at the projection image forming unit.

A camera according to the present invention comprises: the projector described above; and an imaging unit that captures a subject image.

### EFFECT OF THE INVENTION

According to the present invention, the part of the light emitted from the solid-state light emitting element that does not directly enter the optical system is reflected at the reflecting unit and thus travels back to the solid-state light emitting element where it can be used to excite the phosphor.

### BRIEF DESCRIPTION OF THE DRAWINGS

(FIG. 1) A perspective of the front side of the projector-equipped electronic camera achieved in an embodiment of the present invention
(FIG. 2) A perspective of the rear side of the projector-equipped electronic camera achieved in the embodiment
(FIG. 3) A block diagram showing the structure adopted in the projector-equipped electronic camera in the embodiment
(FIG. 4) The structure adopted in the projector unit in the embodiment
(FIG. 5) Sectional views illustrating structures that may be assumed around the LED light source, with FIG. 5(a) showing the LED light source achieved in a first embodiment and FIG. 5 (b) showing the LED light source achieved in a second embodiment
(FIG. 6) Sectional views illustrating structures assumed around light sources in illuminating devices in the related art, with FIG. 6(a) showing an example in which the light emitted toward the sides is not utilized and FIG. 6 (b) showing an example in which the light emitted toward the sides is utilized
(FIG. 7) A sectional view illustrating structure assumed around the light source in the projector achieved in a variation
(FIG. 8) Sectional views illustrating the structures that may be assumed around the LED light source, with FIG. 8 (a) showing the LED light source achieved in a third embodiment and FIG. 8(b) showing the LED light source achieved in a variation

### BEST MODE FOR CARRYING OUT THE INVENTION

### -First Embodiment-

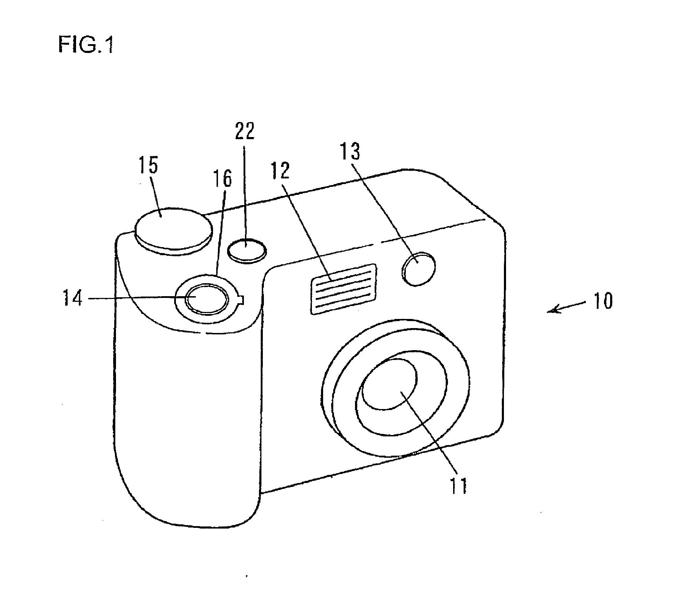

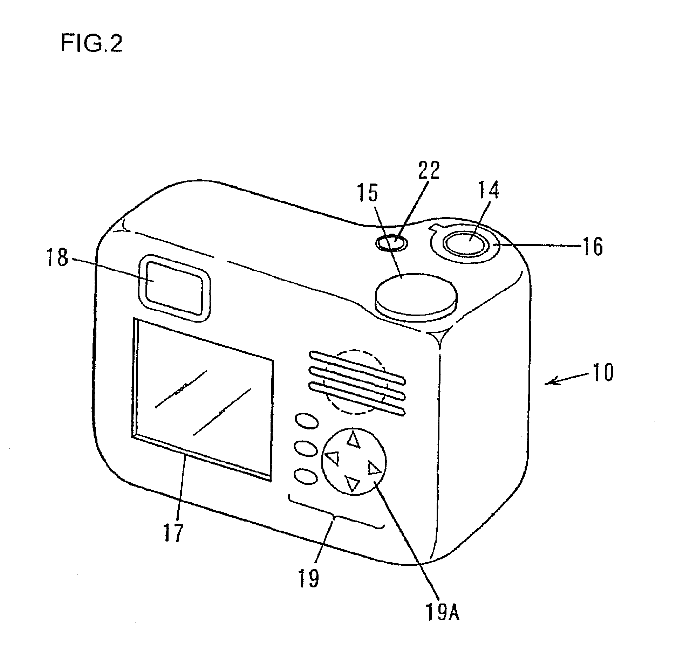

In reference to the drawings, a projector-equipped electronic camera, which includes the illuminating device achieved in the first embodiment of the present invention, is described. As shown in FIG. 1, a photographic lens 11, an illuminating light window 12 and a projection window 13 are disposed at the front of a projector-equipped electronic camera 10. On the upper side of the projector-equipped electronic camera 10, a shutter release button 14, a zoom switch 16, a mode selector dial 15 and a main switch 22 are disposed. In addition, a liquid crystal display unit 17, an electronic viewfinder 18 and a arrow key 19 are disposed on the rear side of the projector-equipped electronic camera 10, as shown in FIG. 2.

A projector device (projectorunit) to be described later is mounted at the projector-equipped electronic camera 10. For instance, information such as an image is projected through the projection window 13 toward a screen or the like placed to the front of the projector-equipped electronic camera 10 set on a desk.

The mode selector dial 15 is the mode switching operation member operated to select an operation mode, such as a photographing mode or a projection mode, for the projector-equipped electronic camera 10. In the photographing mode, a subject image is photographed and the image data resulting from the photographing operation are saved as a photographic image file into a recording medium constituted with a memory card or the like.

In the projection mode, image data resulting from a previous photographing operation are read out from a recording medium (such as a memory card 200 to be detailed later or an internal memory (not shown)) and an image reproduced based upon the image data having been read out is projected through the projection window 13 by the projector unit. It is to be noted that in the projection mode, the projector unit is also able to project an image reproduced based upon image data read out from a source other than a recording medium or image data provided from outside the projector-equipped electronic camera 10.

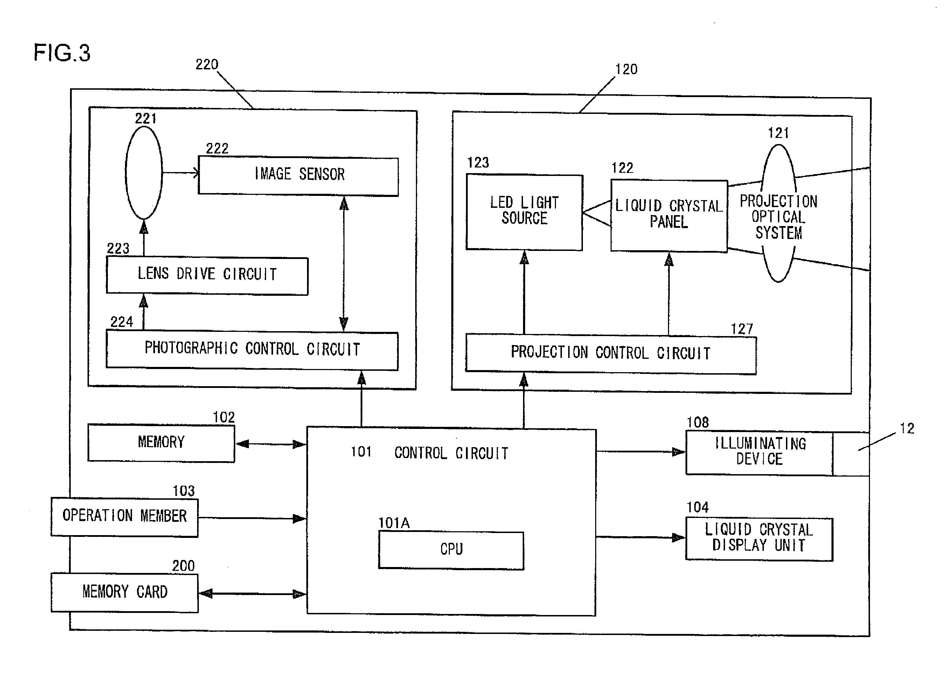

FIG. 3 is a block diagram showing the structure adopted in the projector-equipped electronic camera 10. The projector-equipped electronic camera 10 in FIG. 3 includes a projector unit 120, an imaging unit 220, a memory 102, an operation member 103, a liquid crystal display unit 104 and an illuminating device 108. A memory card 200 can be detachably loaded into a card slot (not shown) at a control circuit 101 constituted with a CPU 101A and the like.

The CPU 101A controls the photographing operation and the projection operation by executing specific arithmetic operations using signals input thereto from various units constituting the projector-equipped electronic camera 10 based upon a control program and outputting control signals resulting from the arithmetic operations to the individual units in the projector-equipped electronic camera 10. It is to be noted that the control program is stored in a non-volatile memory (not shown) within the CPU 101A.

The memory 102 is used as a work memory by the CPU 101A. The operation member 103 corresponds to the main switch 22, the shutter release button 14, the zoom switch 16 and the mode selector dial 15 in FIG. 1 and the arrow key 19 in FIG. 2. The operation member 103 outputs an operation signal corresponding to a specific operation to the CPU 101A.

At the memory card 200, constituted with a nonvolatile memory such as flash memory, data such as image data resulting from a photographing operation executed at the imaging unit 200 can be written, saved and read out in response to commands issued by the CPU 101A.

The illuminating device 108 causes a light emitting member to emit light in response to a light emission command from the CPU 101A and radiates the illuminating light to be used to illuminate the subject toward the space in front of the projector-equipped electronic camera 10 through the illuminating light window 12.

Information such as an image or text is brought up on display at the liquid crystal display unit 104 (17 in FIG. 2) in response to a command issued by the CPU 101A. The text information may indicate the operating state of the projector-equipped electronic camera 10, provide an operation menu or the like.

### (Imaging unit)

The imaging unit 220 includes a photographic lens 221 (11 in FIG. 1), an image sensor 222, a lens drive circuit 223 and a photographic control circuit 224. The image sensor 222 may be a CCD image sensor or a CMOS image sensor. The photographic control circuit 224 controls the image sensor 222 and the lens drive circuit 223 by driving them in response to commands issued by the CPU 101A and also executes specific image processing on imaging signals (stored charge signals) output from the image sensor 222. Such image processing includes white balance correction and gamma correction.

The subject image is formed through the photographic lens 221 onto the imaging surface of the image sensor 222. The photographic control circuit 224 engages the image sensor 222 to start an imaging operation in response to a photographing start instruction, reads out the stored charge signals from the image sensor 222 when the imaging operation ends and outputs image data resulting from the image processing executed on the read out signals to the CPU 101A.

Based upon a focus adjustment signal output from the photographic control circuit 224, the lens drive circuit 223 drives the focus lens (not shown) constituting part of the photographic lens 221 forward/backward along the optical axis. In addition, based upon a zoom adjustment signal output from the photographic control circuit 224, the lens drive circuit 223 drives the zoom lens (not shown) constituting part of the photographic lens 221 forward/backward along the optical axis (toward the telephoto side or the wide-angle side). The desired extent of focus adjustment and the desired extent of zoom adjustment are indicated by the CPU 101A to the photographic control circuit 224.

### (Projector unit)

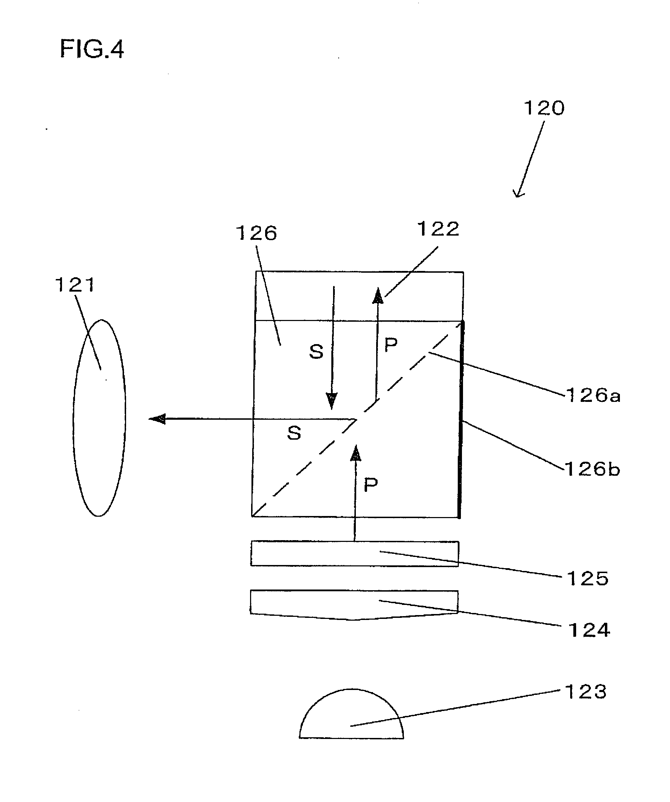

Now, in reference to FIGS. 3 through 5, the projector unit 120 is described. As the block diagram in FIG. 3 and the illustration of the structure adopted in the projector unit in FIG. 4 indicate, the projector unit 120 includes a projection optical system 121, a reflective liquid crystal panel 122, an LED light source 123, a condensing optical system 124, a polarizer 125, a PBS (polarization beam splitter) block 126 and a projection control circuit 127. The reflective liquid crystal panel 122 constituting a projection image forming unit forms a projection image in response to a drive signal provided from the projection control circuit 127. The projection control circuit 127 outputs control signals to the LED light source 123 and the reflective liquid crystal panel 122 in response to a projection command output from the CPU 101A.

The LED light source 123 is constituted with a white-color LED that emits white light as detailed later. The white light is emitted in response to the projection command from the CPU 101A, which is input thereto via the projection control circuit 127. The condensing optical system 124 is a optical collimator system that converts the white light emitted from the LED light source 123 to substantially parallel light, and outputs the substantially parallel light toward the PBS block 126. The PBS block 126 is a polarization beam splitter that includes a polarization splitter unit 126a forming a 45° angle relative to the optical axis of the illuminating light departing the condensing optical system 124. The reflective liquid crystal panel 122 constituted with a reflective liquid crystal element (LCOS) is disposed on the upper side surface of the PBS block 126. The polarizer 125 is disposed by the lower side surface (the surface toward the condenser optical system 124) of the PBS block 126. The liquid crystal panel 122 is illuminated with the illuminating light emitted from the LED light source 123 and transmitted through the polarizer 125. A surface 126b of the PBS block 126 will have undergone an antireflection treatment such as blackening.

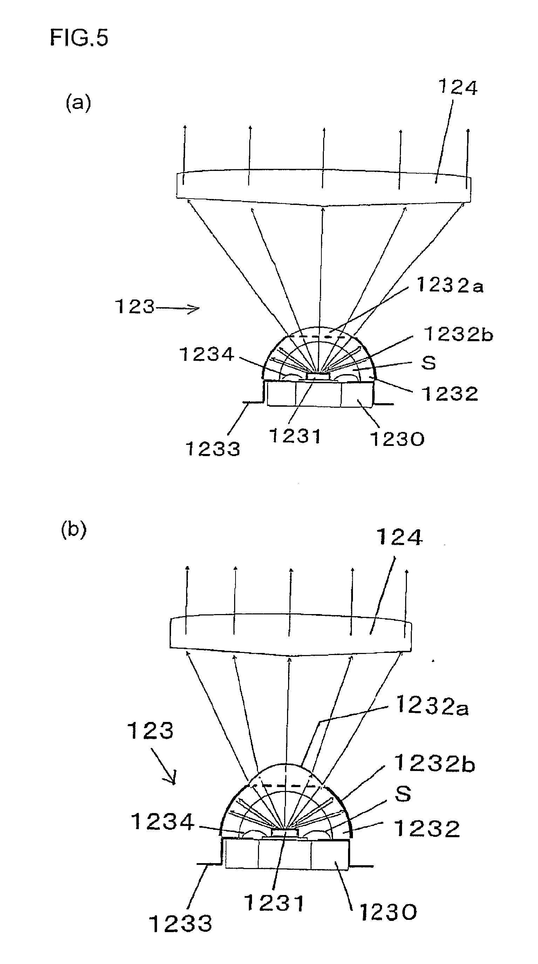

FIG. 5(a) is a sectional view of the LED light source 123 in an enlargement. The LED light source 123 is constituted with a base member 1230, a light emitting diode element (hereafter referred to as an "LED chip") 1231, a cover 1232, an electrode 1233, a wire 1234 and the like. The LED chip 1231 disposed on the base member 1230 is a white color LED formed by covering a light source, constituted with a blue light emitting element (LED), with a yellow light emitting phosphor. Namely, the blue light emitted from the blue light emitting element travels through the yellow light emitting phosphor and is output as light constituted with a blue color component and also excites the yellow light emitting phosphor. As the phosphor is excited, it emits light (phosphorescent light) constituted with a yellow color component. As a result, white light is emitted from the LED chip 1231.

The cover 1232, constituted with a transparent material such as plastic formed in a hemispherical, hollow dome shape, is disposed above the base member 1230 so as to shield the LED chip 1231. The cover 1232 is disposed by substantially aligning the center of its hemispherical shape with the center of the LED chip 1231. In addition, a transparent gel substance assuming a refractive index substantially equal to that of the cover 1232 fills a space S formed between the cover 1232 and the base member 1230.

A reflecting film is formed over the outer circumferential surface of the cover 1232 except over a specific area near its apex. Namely, a transmissive portion 1232a where the light emitted from the LED chip 1231 is transmitted and a reflective portion 1232b at which the emitted light is reflected are formed at the cover 1232. The transmissive portion 1232a is formed at the apex of the cover 1232 and the white light emitted from the LED chip 1231 is transmitted through the transmissive portion to be guided toward the condensing optical system 124. The areal size of the transmissive portion 1232a is determined based upon the numerical aperture of the condensing optical system 124 and the distance between the condensing optical system 124 and the LED chip 1231. In other words, the area over which the transmissive portion 1232a is to range is determined by ensuring that the light having been transmitted through the cover 1232 is allowed to enter the condensing optical system 124 in its entirety.

The reflective portion 1232b is formed so as to reflect the light emitted toward the sides from the LED chip 1231, i.e., the light that will not directly enter the condensing optical system 124 and thus cannot be used as illuminating light, back toward the light source where the light is reused. The reflective portion 1232b may be formed by vapor-depositing aluminum or the like onto the surface of the cover 1232. The reflective portion 1232b is formed at the outer circumferential surface of the hemispherical cover 1232, the center of which is substantially in alignment with the center of the LED chip 1231. Accordingly, the light having been emitted from the LED chip 1231 and reflected at the reflective portion 1232b enters the LED chip 1231 located substantially at the center of the hemisphere. As explained earlier, the areal size of the transmissive portion 1232a is determined based upon the numerical aperture of the condensing optical system 124 and the distance between the condensing optical system 124 and the LED chip 1231 and thus, the light that does not enter the condensing optical system 124 in its entirety at the reflective portion 1232b to travel back to the LED chip 1231.

Reflected light constituted with the blue color component in the light having been reflected at the reflective portion 1232b and having reached the LED chip 1231 excites the yellow light emitting phosphor constituting the LED chip 1231. Since the blue light radiated from the blue light emitting element at the LED chip 1231 excites the yellow light emitting phosphor as explained earlier and the reflected light constituted with the blue color component entering the LED chip also excites the yellow light emitting phosphor, the amount of light emitted from the yellow light emitting phosphor increases. In addition, the part of the reflected blue color component in the light reflected from the reflective portion 1232b, which is not used to excite the phosphor, travels into the LED chip 1231 where it is repeatedly reflected or refracted before it is emitted toward the outside of the LED chip 1231 again. The yellow light in the light having been reflected at the reflective portion 1232b and reached the LED chip 1231 is also repeatedly reflected or refracted inside the LED chip 1231 and then is emitted toward the outside of the LED chip 1231 again.

Part of the light re-emitted from the LED chip 1231 is transmitted through the transmissive portion 1232a, whereas the rest of the light is reflected at the reflective portion 1232b and travels back to the LED chip 1231 through the process described earlier. The light having returned to the LED chip 1231 is emitted from the LED chip 1231 again as explained earlier. As a result, the light emitted toward the sides of the LED chip 1231 can be directed to be transmitted through the transmissive portion 1232a. Consequently, the light reflected at the reflective portion 1232b is reused and the amount of light transmitted through the transmissive portion 1232a increases, achieving a state equivalent to a condition under which the efficiency with which the light emitted from the LED light source 123 is condensed via the condensing optical system 124 improves. Thus, a bright projection image can be obtained with a greater amount of light projected from the projector unit 120.

The operation of the projector unit structured as described above is now described in reference to FIG. 4.

A drive current based upon a control signal issued by the projection control circuit 127 is supplied to the LED chip 1231 via the wire 1234 and the electrode 1233. The LED chip 1231 emits light achieving a luminance level corresponding to the drive current toward the condensing optical system 124. The LED light is converted to substantially parallel light at the condensing optical system 124 and the substantially parallel light is then directed via the condensing optical system to enter the polarizer 125. The incident light having entered the polarizer 125 is converted to linearly polarized light (or linearly polarized light is extracted) at the polarizer, and the polarized light resulting from the conversion (or the extracted polarized light) is then directed toward the PBS block 126.

A polarized light flux (e.g., P-polarized light) having entered the PBS block 126 is transmitted through the PBS block 126 and illuminates the reflective liquid crystal panel 122. The reflective liquid crystal panel 122 functioning as the projection image forming unit is constituted with a plurality of pixels with red, green and blue filters disposed thereat and generates a color image. The light having entered the reflective liquid crystal panel 122 to be transmitted through a liquid crystal layer at the reflective liquid crystal panel 122 advances along the upward direction in FIG. 4 through the liquid crystal layer, is reflected at the reflecting surface of the reflective liquid crystal panel 122, advances along the downward direction in FIG. 4 through the liquid crystal layer and is emitted from the reflective liquid crystal panel 122 to reenter the PBS block 126. Since the liquid crystal layer with a voltage applied thereto functions as a phase plate, the light reentering the PBS block 126 is converted into mixed light that includes modulated light constituted with S-polarized light and unmodulated light constituted with P-polarized light. Only the modulated light constituted with the S-polarized light component in the light flux having reentered the TBS block 126 is reflected (bent) at the polarization splitter unit 126a and is emitted as projection light toward the projection optical system 121 present to the left.

The following advantages are achieved through the first embodiment described above.
(1) The reflective portion 1232a is disposed at the cover 1232 constituting part of the LED light source 123 so as to direct part of the light emitted from the LED chip 1231, which does not enter the condensing optical system 124, back toward the LED chip 1231 to be reused. Namely, the light reflected at the reflective portion 1232b enters the LED chip 1231 where it repeatedly excites the phosphor, and/or is reflected before it is emitted toward the condenser optical system 124. As a result, even light LA from an LED light source 223 in the related art shown in FIG. 6(a), which is emitted toward the sides of the LED chip 223a and could not otherwise be effectively utilized, can be used efficiently, which, in turn, improves the efficiency with which the light emitted from the LED light source 123 is condensed and increases the amount of emitted light.
(2) The light emitted toward the sides is reflected at the reflective portion 1232b and is thus directed back to the LED chip 1231. Consequently, since no unnecessary illuminating light is emitted to the outside of the LED light source 123, the occurrence of any undesirable phenomenon such as flaring in the projection image is suppressed.
(3) While the light emitted toward the sides is converted to parallel light by reflecting it with a total reflection optical system 324 with a paraboloid of revolution at an LED light source 323 in the related art shown in FIG. 6(b), the LED light source in the related art also requires a refractive optical system 325 to be used in combination. In contrast, the need for the combined use of the refractive optical system and the total reflection optical system is eliminated in the LED chip 1231 in the embodiment, making it possible to provide the illuminating device as a compact unit.
(4) The LED chip 1231 is a white color LED that emits white light constituted with the blue light emitted from the LED and the yellow light emitted as the phosphor is excited with the blue light. At the LED chip 1231 achieving the characteristics described above, the yellow light emitting phosphor can also be excited with the blue light reflected from the reflection portion 1232b. Namely, the light emitted toward the side of the LED chip 1231, which is not utilized as projection light (illuminating light) in the related art, is reused to excite the phosphor so as to increase the amount of light emitted from the LED light source 123.
(5) The areal size of the transmissive portion 1232a is determined based upon the numerical aperture of the condensing optical system 124 and the distance between the condensing optical system 124 and the LED chip 1231, and the reflective portion 1232b is formed to range over the entire area excluding the transmissive portion 1232a. This means that the light that is not guided to the condenser optical system 124 is all reflected at the reflective portion 1232b and thus canbe reused. As a result, the light utilization efficiency is improved and the amount of light entering the condenser optical system 124 from the LED light source 123 is increased.

### -Second Embodiment-

A projector-equipped electronic camera, which includes the illuminating device achieved in the second embodiment of the present invention, is described. The projector-equipped electronic camera in the second embodiment assumes a configuration similar to the projector-equipped electronic camera shown in FIGS. 1 - 4 in reference to which the first embodiment has been described. The following explanation focuses on the feature differentiating the projector-equipped electronic camera from that in the first embodiment.

The projector-equipped electronic camera 10 in the second embodiment includes an LED light source 123 in the projector unit 120, which assumes a shape different from that of the LED light source in the first embodiment. FIG. 5(b) is a sectional view of the LED light source 123 in the second embodiment in an enlargement. As shown in FIG. 5 (b), a cover 1232 disposed so as to shield the LED chip 1231 includes a transmissive portion 1232a and a reflective portion 1232b formed through aluminum vapor deposition or the like, as does the cover in the first embodiment. The transmissive portion 1232a at the cover 1232 is formed as a lens with a small radius of curvature with a positive refractive index, which projects out further toward the condenser optical system 124 relative to the side surface where the reflective portion 1232b is formed. Thus, the lens diameter at the condensing optical system 124 can be set smaller than that in the condensing optical system 124 in the first embodiment, which is bound to contribute to miniaturization of the illumination unit in the projector 120.

### -Third Embodiment-

A projector-equipped electronic camera, which includes the illuminating device achieved in the second embodiment of the present invention, is described. The projector-equipped electronic camera in the third embodiment assumes a configuration similar to the projector-equipped electronic camera shown in FIGS. 1 - 4 in reference to which the first embodiment has been described. The following explanation focuses on the feature differentiating the projector-equipped electronic camera from that in the first embodiment.

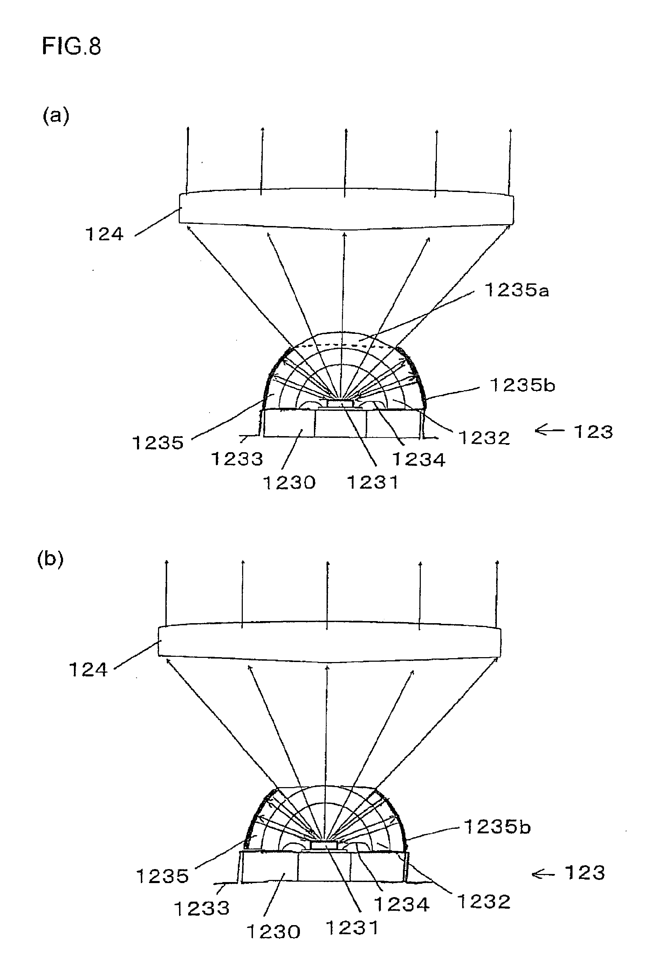

The LED light source 123 in the projector-equipped electronic camera 10 in the third embodiment differs from the LED light source 123 in the first embodiment in that it includes a cap having a transmissive portion and a reflective portion, instead of forming a transmissive portion 1232a and a reflective portion 1232b at the cover 1232 of the LED light source. FIG. 8 (a) is a sectional view of the LED light source 123 achieved in the third embodiment in an enlargement. As shown in FIG. 8(a), the LED light source 123 includes a cap 1235 constituted with a transparent material with a refractive index substantially equal to that of the cover 1232 formed into a hemispherical, hollow dome shape so as to shield the cover 1232. The cap 1235 is disposed at the outer surface of the cover 1232 by ensuring that the center of the hemisphere is substantially aligned with the center of the LED chip 1231. It is to be noted that the cap 1235 and the cover 1232 may be placed in tight contact with each other, as shown in FIG. 8(a) or they may be positioned so as to form a space between the cap 1235 and the cover 1232. Any space that may be formed between the cap 1235 and the cover 1232 should be filled with a transparent gel substance having a refractive index substantially equal to those of the cap 1235 and the cover 1232.

As does the cover 1232 in the first embodiment, the cap 1235 includes a transmissive portion 1235a and a reflective portion 1235b constituted of, for instance, aluminum vapor-deposited onto the outer circumferential surface of the cap 1235. Thus, the white light emitted from the LED chip 1231 is transmitted through the cover 1232 and the transmissive portion 1235a and is guided toward the condensing optical system 124. In addition, the white light transmitted through the cover 1232 and reflected at the reflective portion 1235b is retransmitted through the cover 1232 and returns to the LED chip 1231. Thus, the part of the light emitted from the LED chip 1231, which does not enter the condensing optical system 124, is directed back to the LED chip 1231 where it can be reused.

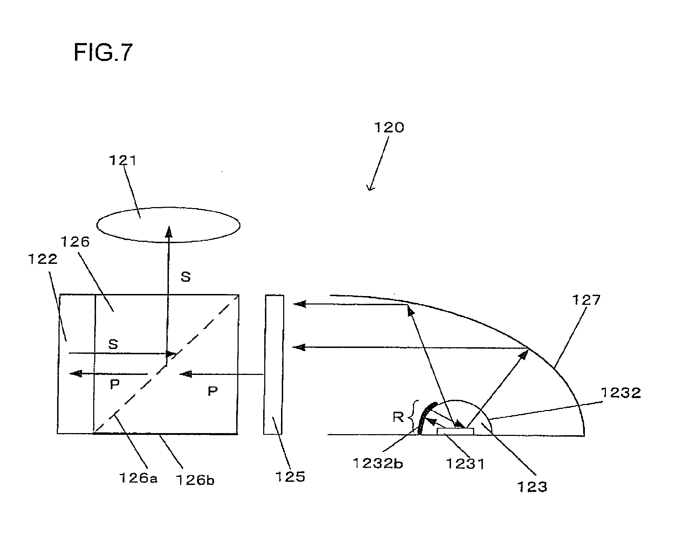

The illuminating devices achieved in the first, second and third embodiments, as described above, allow for the following variations.
(1) A structure such as that shown in FIG. 7 may be achieved by combining the LED light source 123 and a reflecting surface. FIG. 7 shows a reflecting optical system 127 that has a reflecting surface assuming the shape of a paraboloid of revolution disposed around the LED light source 123. The light emitted from the LED light source 123 is totally reflected at the reflecting optical system 127 and becomes parallel light. The parallel light is then emitted toward the PBS block 126 through an opening portion at the reflecting optical system 127. In this case, a reflective portion 1232b is formed at the LED light source 123 to range over an area R at the side surface of the cover 1232 located toward the PBS block 126. The light reflected at the reflective portion 1232b travels back to the LED chip 1231 as explained earlier. If no reflective portion 1232b were formed over the range R, the light emitted from the LED light source 123 would enter the PBS block 123 along diagonal directions. However, the presence of the reflective portion 1232b occupying the range R allows only the light having been reflected at the reflecting optical system 127 and having become parallel light, to enter the PBS block 126. It is to be noted that since light emitted from the reflecting optical system 127 in the variation shown in FIG. 7 is substantially parallel light, the variation does not require the condensing optical system 124 used in the embodiments.
(2) The reflective portion 1232b or 1235b may be constituted with a dichroic mirror that reflects the blue light. With the reflective portion constituted with a dichroic mirror, it can be ensured that only light constituted with the blue color component is reflected at the dichroic mirror and reenters the LED chip 1231 after light is initially emitted from the LED chip 1231. The use of such a reflective portion reduces the ratio of the yellow light in the white light re-emitted from the LED chip over a reflective portion that reflects light containing the yellow color component.
(3) The LED light source 123 may emit white light via three LED chips that emit R-color light, G-color light and B-color light. In such a case, the light having been reflected at the reflective portion and having been directed back to the three LED chips is repeatedly reflected within the LED light source 123 before it is emitted to the outside. As a result, the part of the light that is not effectively utilized in the related art is used efficiently to contribute toward an increase in the amount of light emitted from the LED light source.
(4) Instead of the reflective portion 1232b constituted of aluminum vapor-deposited onto the outer circumferential surface of the cover 1232, a reflective portion 1232b may be formed at the inner circumferential area of the cover 1232. In addition, instead of the reflective portion 1235b constituted of aluminum or the like vapor deposited onto the outer circumferential surface of the cap 1235, a reflective portion 1235b may be formed over the inner circumferential area of the cap 1235.
(5) The excitation-type light emitting diode chip 1231 described above is an excitation-type white color LED chip that outputs white light and is equipped with an LED light emitting element that emits blue light and a phosphor that is excited with the blue light and emits yellow light. However, the present invention is not limited to this example and any of various other types of LED chips may be used in conjunction with the present invention.
(6) The present invention may also be adopted in a portable telephone or a portable electronic device such as a PDA unit equipped with the projector unit 120.
(7) The cap 1235 in the third embodiment may assume an alternative shape such as that shown in the sectional view in FIG. 8(b). Namely, the cap 1235 may assume a ring shape achieved by cutting off the transmissive portion 1235a in the third embodiment, with the reflective portion 1235b formed either over the outer circumferential surface or over the inner circumferential surface of the cap 1235.
(8) The present invention may be adopted in conj unction with any of various other solid-state light emitting elements, instead of the light emitting diode described in reference to the embodiments.

While the invention has been particularly shown and described with respect to preferred embodiments thereof by referring to the attached drawings, the present invention is not limited to these examples and it will be understood by those skilled in the art that various changes in form and detail may be made therein without departing from the scope and teaching of the invention.

## Claims

1. An illuminating device, comprising:
an optical system (124)
a solid-state light emitting element (123) that includes a light source (1231) disposed on a base member (1230), the light source (1231) being coated with phosphor and adapted to emit a first light toward the optical system (124), the first light comprising a second light emitted from the light source (1231) and phosphorescent light emitted from the phosphor excited with the second light from the light source (1231); and
**characterized by**
a cover member (1232) having a hollow hemispherical form and disposed above the_base member (1230),
wherein a reflective film is formed on a reflective portion (1232b) corresponding to an outer surface of the cover member (1232) except a transmissive portion (1232a) located at the apex of the cover member (1232),
wherein the reflective portion (1232b) is configured to reflect a part of the first light emitted from the solid-state light emitting element (123), which is not directed toward the optical system (124), back to the solid-state light emitting element (123)directly so that the reflected light is used to excite the phosphor,and
wherein the transmissive portion (1232a) is located at the apex of the cover member (1232) in correspondence to the optical system (124) for transmitting another part of the first light directed toward the optical system (124).

2. An illuminating device according to claim 1, wherein:
the solid-state light emitting element (123) is adapted to emit the first light as white light.

3. An illuminating device according to claim 1, wherein:
the second light emitted from the light source (1231) is blue light constituted of a blue color component and the phosphor are adapted to emit yellow light constituted of a yellow color component as the phosphor is excited with exciting light constituted with the blue light.

4. An illuminating device according to any one of claims 1 through 3, wherein:
the reflective portion (1232b) is a dichroic mirror that reflects a component of exciting light.

5. An illuminating device according to any one of claims 1 through 4, wherein:
the optical system (124) is configured to condense the first light emitted from the solid-state light emitting element (123) and to emit the condensed light.

6. An illuminating device according to claim 5, wherein:
the optical system (124) is an optical collimator system adapted to convert the first light emitted from the solid-state light emitting element (123) to substantially parallel light and then to emit the substantially parallel light.

7. An illuminating device according to claim 5 or claim 6, wherein:
the areal size of the transmissive portion (1232a) is determined in correspondence to a numerical aperture of the optical system (124) and a distance between the optical system (124) and the solid-state light emitting element (123).

8. An illuminating device according to any one of claims 1 through 7, wherein:
the cover member (1232) is disposed so that a center of the hollow hemispherical form is aligned with a center of the solid-state light emitting element (123), wherein:
the reflective portion (1232b) is disposed at a surface of the cover member (1232).

9. An illuminating device according to claim 8, wherein:
the cover member (1232) includes a first area where the reflective portion (1232b) is disposed and a second area (1232a) through which a part of the first light directed toward the optical system (124) is transmitted; and
a radius of curvature of the second area is smaller than a radius of curvature of the first area and the second area has a positive refractive power.

10. An illuminating device according to any one of claims 1 through 7, further comprising:
a cover member (1232) assuming a hollow hemispherical form and disposed so that a center of the hemispherical hollow form is aligned with a center of the solid-state light emitting element (123); and
a dome member (1235) disposed in close contact with an outer surface of the cover member (1232), wherein:
the reflective portion (1235b) is disposed at a surface of the dome member (1235).

11. A projector (120), comprising:
a projection image forming unit (122) for forming a projection image to be projected;
an illuminating device according to any one of claims 1 through 10, for illuminating the projection image forming unit (122); and
a projection optical system (121) for projecting an image formed at the projection image forming unit (122).

12. A camera (100), comprising:
a projector (120) according to claim 11; and
an imaging unit (220) for capturing a subject image.

## Patentansprüche

1. Beleuchtungsvorrichtung, aufweisend:
ein optisches System (124),
ein Festkörper-Lichtemissionselement (123), das eine Lichtquelle (1231), die auf einem Basiselement (1230) angeordnet ist, aufweist, wobei die Lichtquelle (1231) mit Phosphor beschichtet ist und angepasst ist, um ein erstes Licht zum optischen System (124) zu emittieren, wobei das erste Licht ein zweites Licht, das von der Lichtquelle (1231) emittiert wird, und phosphoreszierendes Licht, das vom Phosphor emittiert wird, der mit dem zweiten Licht von der Lichtquelle (1231) angeregt wird, aufweist;
und
**gekennzeichnet durch**
ein Abdeckelement (1232), das die Form einer hohlen Halbkugel aufweist und über dem Basiselement (1230) angeordnet ist,
wobei ein reflektierender Film auf einem reflektierenden Abschnitt (1232b), der einer Außenfläche des Abdeckelements (1232) entspricht, mit Ausnahme eines am Scheitel des Abdeckelements (1232) befindlichen lichtdurchlässigen Abschnitts (1232a) ausgebildet ist,
wobei der reflektierende Abschnitt (1232b) konfiguriert ist, um einen Teil des vom Festkörper-Lichtemissionselement (123) emittierten ersten Lichts, der nicht zum optischen System (124) hin gerichtet ist, direkt zum Festkörper-Lichtemissionselement (123) zurück zu reflektieren, so dass das reflektierte Licht verwendet wird, um den Phosphor anzuregen, und
wobei der lichtdurchlässige Abschnitt (1232a) am Scheitel des Abdeckelements (1232) korrespondierend mit dem optischen System (124) angeordnet ist, um einen weiteren Teil des ersten Lichts, der zum optischen System (124) hin gerichtet ist, zu übertragen.

2. Beleuchtungsvorrichtung nach Anspruch 1, wobei:
das Festkörper-Lichtemissionselement (123) angepasst ist, um das erste Licht als weißes Licht zu emittieren.

3. Beleuchtungsvorrichtung nach Anspruch 1, wobei:
das zweite Licht, das von der Lichtquelle (1231) emittiert wird, blaues Licht ist, das aus einer blauen Farbkomponente gebildet wird, und der Phosphor angepasst ist, um gelbes Licht, das aus einer gelben Farbkomponente gebildet wird, zu emittieren, wenn der Phosphor mit anregendem Licht, das mit dem blauen Licht gebildet wird, angeregt wird.

4. Beleuchtungsvorrichtung nach einem der Ansprüche 1 bis 3, wobei:
der reflektierende Abschnitt (1232b) ein dichroitischer Spiegel ist, der eine Komponente des anregenden Lichts reflektiert.

5. Beleuchtungsvorrichtung nach einem der Ansprüche 1 bis 4, wobei:
das optische System (124) konfiguriert ist, um das erste Licht, das vom Festkörper-Lichtemissionselement (123) emittiert wird, zu kondensieren und das kondensierte Licht zu emittieren.

6. Beleuchtungsvorrichtung nach Anspruch 5, wobei:
das optische System (124) ein optisches Kollimatorsystem ist, das angepasst ist, um das erste Licht, das vom Festkörper-Lichtemissionselement (123) emittiert wird, in im Wesentlichen paralleles Licht zu konvertieren und anschließend das im Wesentlichen parallele Licht zu emittieren.

7. Beleuchtungsvorrichtung nach Anspruch 5 oder Anspruch 6, wobei:
die flächenmäßige Größe des lichtdurchlässigen Abschnitts (1232a) entsprechend einer numerischen Apertur des optischen Systems (124) und einem Abstand zwischen dem optischen System (124) und dem Festkörper-Lichtemissionselement (123) bestimmt ist.

8. Beleuchtungsvorrichtung nach einem der Ansprüche 1 bis 7, wobei:
das Abdeckelement (1232) derart angeordnet ist, dass eine Mitte der hohlen Halbkugelform mit einer Mitte des Festkörper-Lichtemissionselements (123) fluchtet, wobei:
der reflektierende Abschnitt (1232b) an einer Oberfläche des Abdeckelements (1232) angeordnet ist.

9. Beleuchtungsvorrichtung nach Anspruch 8, wobei:
das Abdeckelement (1232) einen ersten Bereich, in dem der reflektierende Abschnitt (1232b) angeordnet ist, und einen zweiten Bereich (1232a), durch den ein Teil des ersten Lichts, der zum optischen System (124) hin gerichtet ist, übertragen wird, aufweist; und
ein Krümmungsradius des zweiten Bereichs kleiner als ein Krümmungsradius des ersten Bereichs ist und der zweite Bereich eine positive Brechkraft aufweist.

10. Beleuchtungsvorrichtung nach einem der Ansprüche 1 bis 7, weiterhin aufweisend:
ein Abdeckelement (1232), das eine hohle Halbkugelform annimmt und derart angeordnet ist, dass eine Mitte der hohlen Halbkugelform mit einer Mitte des Festkörper-Lichtemissionselements (123) fluchtet; und
ein Kuppelglied (1235), das in engem Kontakt mit einer Außenfläche des Abdeckelements (1232) angeordnet ist, wobei:
der reflektierende Abschnitt (1235b) an einer Oberfläche des Kuppelglieds (1235) angeordnet ist.

11. Projektor (120), aufweisend:
eine Projektionsbilderzeugungseinheit (122) zum Erzeugen eines zu projizierenden Projektionsbildes;
eine Beleuchtungsvorrichtung nach einem der Ansprüche 1 bis 10 zum Beleuchten der Projektionsbilderzeugungseinheit (122); und
ein optisches Projektionssystem (121) zum Projizieren eines Bildes, das in der Projektionsbilderzeugungseinheit (122) erzeugt wird.

12. Kamera (100), aufweisend:
einen Projektor (120) nach Anspruch 11; und
eine Abbildungseinheit (220) zum Aufnehmen eines Gegenstandsbildes.

## Revendications

1. Dispositif d'éclairage, comprenant:
un système optique (124),
un élément électroluminescent à l'état solide (123) qui comprend une source lumineuse (1231) disposée sur un élément de base (1230), la source lumineuse (1231) étant revêtue de phosphore et adaptée pour émettre une première lumière vers le système optique (124), la première lumière comprenant une seconde lumière émise par la source lumineuse (1231) et de la lumière phosphorescente émise par le phosphore excité par la seconde lumière de la source lumineuse (1231) ;
et
**caractérisé par**
un élément couvercle (1232) présentant une forme hémisphérique creuse et étant disposé au-dessus de l'élément de base (1230),
un film réfléchissant étant formé sur une partie réfléchissante (1232b) correspondant à une surface externe de l'élément couvercle (1232) à l'exception d'une partie transmettant la lumière (1232a) située au sommet de l'élément couvercle (1232),
une partie réfléchissante (1232b) étant configurée pour renvoyer une partie de la première lumière émise par l'élément électroluminescent à l'état solide (123) qui n'est pas dirigée vers le système optique (124) directement à l'élément électroluminescent à l'état solide (123) de sorte que la lumière réfléchie soit utilisée pour exciter le phosphore, et
la partie transmettant la lumière (1232a) étant située au sommet de l'élément couvercle (1232) en correspondance avec le système optique (124) pour transmettre une autre partie de la première lumière qui est dirigée vers le système optique (124).

2. Dispositif d'éclairage selon la revendication 1, dans lequel :
l'élément électroluminescent à l'état solide (123) est adapté pour émettre la première lumière en tant que lumière blanche.

3. Dispositif d'éclairage selon la revendication 1, dans lequel :
la seconde lumière émise par la source lumineuse (1231) est de la lumière bleue constituée d'une composante de couleur bleue, et le phosphore est adapté pour émettre de la lumière jaune constituée d'une composante de couleur jaune lorsque le phosphore est excité par de la lumière excitante constituée de la lumière bleue.

4. Dispositif d'éclairage selon l'une des revendications 1 à 3, dans lequel :
la partie réfléchissante (1232b) est un miroir dichroïque qui réfléchit une composante de lumière excitante.

5. Dispositif d'éclairage selon l'une des revendications 1 à 4, dans lequel :
le système optique (124) est configuré pour condenser la première lumière émise par l'élément électroluminescent à l'état solide (123) et pour émettre la lumière condensée.

6. Dispositif d'éclairage selon la revendication 5, dans lequel :
le système optique (124) est un système de collimateur optique adapté pour convertir la première lumière émise par l'élément électroluminescent à l'état solide (123) en une lumière sensiblement parallèle et pour ensuite émettre la lumière sensiblement parallèle.

7. Dispositif d'éclairage selon la revendication 5 ou 6, dans lequel :
la taille en superficie de la partie transmettant la lumière (1232a) est déterminée en correspondance avec une ouverture numérique du système optique (124) et une distance entre le système optique (124) et l'élément électroluminescent à l'état solide (123).

8. Dispositif d'éclairage selon l'une des revendications 1 à 7, dans lequel :
l'élément couvercle (1232) est disposé de telle manière qu'un centre de la forme hémisphérique creuse soit aligné sur un centre de l'élément électroluminescent à l'état solide (123), dans lequel :
la partie réfléchissante (1232b) est disposée sur une surface de l'élément couvercle (1232).

9. Dispositif d'éclairage selon la revendication 8, dans lequel :
l'élément couvercle (1232) comprend une première zone dans laquelle est disposée la partie réfléchissante (1232b) et une seconde zone (1232a) par laquelle est transmise une partie de la première lumière dirigée vers le système optique (124) ; et
un rayon de courbure de la seconde zone est inférieur à un rayon de courbure de la première zone, et la seconde zone a une puissance de réfraction positive.

10. Dispositif d'éclairage selon l'une des revendications 1 à 7, comprenant en outre :
un élément couvercle (1232) adoptant une forme hémisphérique creuse et étant disposé de telle manière qu'un centre de la forme hémisphérique creuse soit aligné sur un centre de l'élément électroluminescent à l'état solide (123) ; et
un élément en forme de dôme (1235) disposé en contact étroit avec une surface externe de l'élément couvercle (1232), dans lequel :
la partie réfléchissante (1235b) est disposée sur une surface de l'élément en forme de dôme (1235).

11. Projecteur (120), comprenant :
une unité de formation d'une image de projection (122) pour former une image de projection à être projetée ;
un dispositif d'éclairage selon l'une des revendications 1 à 10, destiné à éclairer l'unité de formation d'une image de projection (122) ; et
un système optique de projection (122) pour projeter une image formée au niveau de l'unité de formation d'une image de projection (122).

12. Caméra (100), comprenant :
un projecteur (120) selon la revendication 11 ; et
une unité d'imagerie (220) pour capturer une image de sujet.
